# EUROPEAN PATENT SPECIFICATION

(11) **EP 4 411 995 B1**
(45) Date of publication and mention of the grant of the patent: **01.10.2025**
(21) Application number: 23155082.3
(22) Date of filing: 06.02.2023
(51) Int. Cl.: H01R 12/58, H01R 13/10, H01R 43/16, H01L 23/498

(54) **METHOD FOR FORMING A TERMINAL ELEMENT, TERMINAL ELEMENT, AND POWER SEMICONDUCTOR MODULE ARRANGEMENT COMPRISING A TERMINAL ELEMENT**
VERFAHREN ZUR BILDUNG EINES ANSCHLUSSELEMENTS, ANSCHLUSSELEMENT UND LEISTUNGSHALBLEITERMODULANORDNUNG MIT EINEM ANSCHLUSSELEMENT
PROCÉDÉ DE FORMATION D'UN ÉLÉMENT DE BORNE, ÉLÉMENT DE BORNE ET ENSEMBLE DE MODULES SEMI-CONDUCTEURS DE PUISSANCE COMPRENANT UN ÉLÉMENT DE BORNE

(43) Date of publication of application: 07.08.2024
(73) Proprietor: Infineon Technologies AG, 85579 Neubiberg (DE)
(72) Inventor: BÖNIG, Guido, 59581 Warstein (DE); HOHLFELD, Olaf, 29581 Warstein (DE); MICHALSKI, Sebastian, 13347 Berlin (DE)
(74) Representative: Westphal, Mussgnug & Partner, Patentanwälte mbB

(56) References cited:
- JP-A- 2019 138 658
- JP-A- H09 129 285
- US-A- 4 466 689
- US-A1- 2010 014 269
- US-B2- 10 340 217

## Description

### TECHNICAL FIELD

The instant disclosure relates to a method for forming a terminal element, a terminal element, and to a power semiconductor module arrangement comprising a terminal element.

### BACKGROUND

Document US 4 466 689 A discloses a terminal arrangement for interconnecting electrical conductors including a plastic block in which are supported a plurality of terminals arranged in rows and columns. Each terminal is formed from a flat strip of metallic material as the strip is advanced through a progressive punch and die apparatus. The terminal includes a first portion which has a seam that is welded to join butted longitudinal edges of that portion after it has been formed into a cylindrical shape from a flat blank on the strip. After its seam has been welded, the first portion is internally threaded to receive a terminal screw. A second portion of the terminal, which is formed integrally with the first portion, has a generally square cross-section. The second portion of each terminal is disposed in a similarly configured cavity of the plastic block to prevent relative rotational movement between the terminal and the block. Also, the second portion is seamed longitudinally by shear keys which resist axial forces that are imparted to the terminal during installation and use. A conductor-connecting portion, such as a wire wrapping tang, extends from the second portion to receive a conductor of a feeder or distribution cable, for example. Conductors are connected to terminals by terminal screws to connect selected conductors of a feeder cable to selected conductors of a distribution cable.

Documents US 2010/014269 A1 and US 10 340 217 B2 disclose terminals comprising a cylindrical sleeve with an inner thread and an elongated second section which are not manufactured from a stamped and folded metal plate.

Power semiconductor module arrangements often include at least one substrate (e.g., ceramic substrate) arranged in a housing. A semiconductor arrangement including a plurality of controllable semiconductor elements (e.g., IGBTs, diodes, or other semiconductor devices) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. The controllable semiconductor devices are usually mounted to the substrate by soldering or sintering techniques. Additional controllable semiconductor devices may also be arranged on a printed circuit board arranged in parallel to the at least one substrate inside the housing.

Electrical lines or electrical connections are used to connect different semiconductor devices of the power semiconductor arrangement with each other. Further, terminal elements, bus bars or conductor rails are provided to contact the semiconductor arrangement from the outside of the housing. Such terminal elements, bus bars and conductor rails are usually electrically coupled to the substrate or to a printed circuit board of the arrangement with a first end. A second end of the terminal elements, bus bars and conductor rails protrudes out of the housing such that the second end can be electrically contacted. In order to form a permanent electrical and mechanical connection between the second end of the terminal element, conductor rail or bus bar, and an external connector element, different connection techniques are known which, however, are often cumbersome and cost-intensive.

There is a need for a terminal element for a power semiconductor module arrangement, a method for forming a terminal element, and for a power semiconductor module arrangement comprising a terminal element that may be produced easily and cost-effectively.

### SUMMARY

A method includes stamping a blank from a metal sheet, the blank including a first section, and a second section directly adjoining the first section, wherein the second section is an elongated section having a length in a vertical direction that is at least twice its width in a first horizontal direction, and the first section is a rectangular section having a width in the first horizontal direction that is greater than the width of the second section, forming a thread on a surface of the first section, and bending the first section around a cylinder axis to form a round sleeve, wherein the sleeve includes an opening facing in the vertical direction towards the second section.

A terminal element includes a metal piece, the metal piece including a first section, and a second section directly adjoining the first section, wherein the second section is an elongated section having a length in a vertical direction that is at least twice its width in a first horizontal direction, the first section forms a round sleeve around a cylinder axis, wherein the sleeve includes an opening facing in the vertical direction towards the second section, and the first section includes a thread on its inner surface.

A power semiconductor module arrangement includes a housing, a substrate arranged in or forming a bottom of the housing, the substrate including a dielectric insulation layer and a first metallization layer attached to the dielectric insulation layer, a semiconductor arrangement arranged on the substrate, and one or more terminal elements, wherein a first end of each of the one or more terminal elements is arranged inside the housing, and a second end of each of the one or more terminal elements extends to the outside of the housing.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 schematically illustrates a top view of a power semiconductor module arrangement.
Figure 3, including Figures 3A and 3B, schematically illustrates steps of a method for forming a terminal element.
Figure 4, including Figures 4A and 4B, schematically illustrates further steps of a method for forming a terminal element according to one example.
Figure 5 schematically illustrates an even further step of a method for forming a terminal element according to one example.
Figure 6 schematically illustrates flowlines of a material after thread cutting (left) and after forming a thread by compressing the material (right).
Figure 7, including Figures 7A and 7B, schematically illustrates an even further step of a method for forming a terminal element according to one example.
Figure 8 schematically illustrates a cross-sectional view of a power semiconductor module arrangement comprising a terminal element according to one example.
Figure 9 schematically illustrates a cross-sectional view of a power semiconductor module arrangement comprising a terminal element according to another example.
Figure 10 schematically illustrates a top view of a terminal element according to one example.
Figure 11 schematically illustrates a cross-sectional view of the terminal element according to the example of Figure 10 in a first direction.
Figure 12 schematically illustrates a cross-sectional view of the terminal element according to the example of Figure 10 in a second direction.
Figure 13 schematically illustrates a top view of a terminal element according to another example.
Figure 14 schematically illustrates a cross-sectional view of a terminal element according to an even further example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

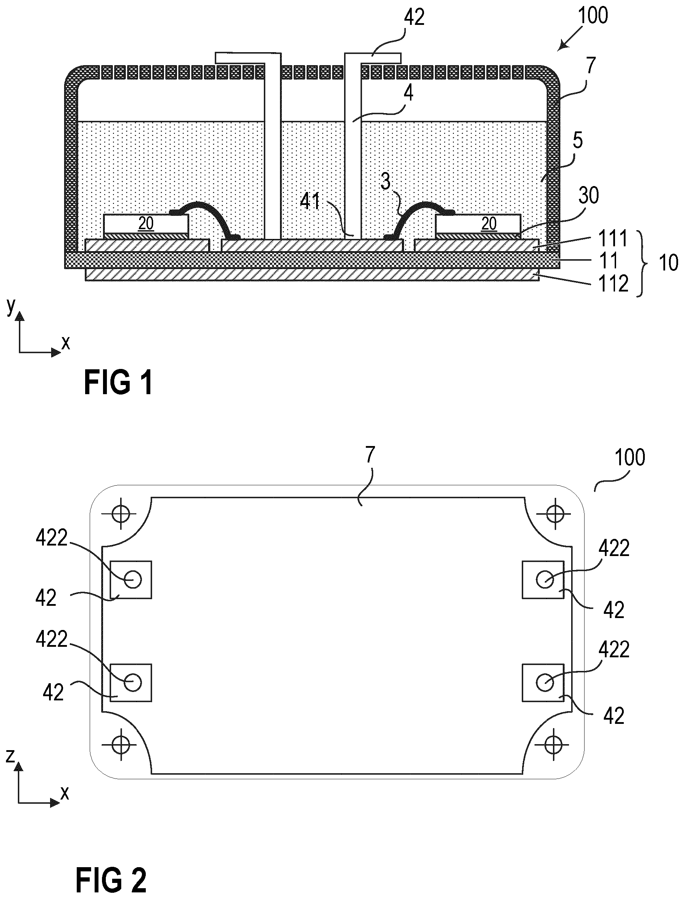

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a second (structured) metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement 100. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AIN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 may be arranged in a housing 7. In the example illustrated in Figure 1, the substrate 10 forms a ground surface of the housing 7, while the housing 7 itself solely comprises sidewalls and a cover. This is, however, only an example. It is also possible that the housing 7 further comprises a ground surface and the substrate 10 be arranged on the ground surface inside the housing 7. According to another example, the substrate 10 may be mounted on a base plate (not illustrated). In some power semiconductor module arrangements 100, more than one substrate 10 is arranged on the ground surface of a housing 7 or on a single base plate (not illustrated). A base plate may form a ground surface of the housing 7, for example.

One or more semiconductor bodies 20 may be arranged on the at least one substrate 10 (e.g., on the first metallization layer 111). Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include bonding ribbons, connection plates or conductor rails, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver powder, for example. According to other examples, it is also possible that the second metallization layer 112 is a structured layer. It is further possible to omit the second metallization layer 112 altogether.

The power semiconductor module arrangement 100 illustrated in Figure 1 further includes a plurality of terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second end 42. In the example illustrated in Figure 1, a first part of the terminal elements 4 extends through the inside of the housing 7 in a vertical direction y. The vertical direction y is a direction perpendicular to a top surface of the substrate 10, wherein the top surface of the substrate 10 is a surface on which the at least one semiconductor body 20 is mounted. The second ends 42 of the terminal elements 4 are bent such that they extend in a first horizontal direction x which is parallel to the top surface of the substrate 10. In this way, for some applications it may be easier to electrically contact the second ends 42. The terminal elements 4 illustrated in Figure 1, however, are only examples. Terminal elements 4 generally may be arranged anywhere within the housing 7. For example, one or more terminal elements 4 may be arranged close to or adjacent to the sidewalls of the housing 7.

The terminal elements 4 may be configured to conduct control signals to and from the substrate 10, for example. Control signals usually comprise electrical signals of 15V or less and are configured to control the function of the different semiconductor bodies 20. Control signals, however, may also comprise electrical signals of more than 15V. It is further possible that supply voltages / load currents are provided to the power semiconductor module arrangement 100 by means of the terminal elements 4. The power semiconductor module arrangement 100 may switch from an off state (non-working state) to an on state (working state), for example, when a supply voltage is provided. Supply voltages may be voltages of more than 100V, for example.

Figure 2 schematically illustrates a top view of a power semiconductor module arrangement 100. In this top view, the housing 7 (i.e., the lid or cover of the housing 7) conceals any components arranged inside the housing 7. Therefore, the substrate 10 and any components arranged thereon are not visible in the top view of Figure 2. Figure 2, however, illustrates the second ends 42 of the plurality of terminal elements 4, which protrude to the outside of the housing 7. As has been described with respect to Figure 1 above, the second ends 42 of the terminal elements 4 may be bent such that they extend in a first horizontal direction x which is parallel to the top surface of the substrate 10. A hole 422 may be provided in each of the second ends 42, for example. When contacting the terminal elements 4 with an external connector element, the connector element may be inserted into the hole 422, for example. It is also possible that a connection between the external connector element and the terminal element 4 be formed by means of a screw that is inserted through a hole in the external connector element and the hole in the terminal element 4, thereby pressing together the external connector element and the terminal element 4. This may require a nut being arranged between the terminal element (the horizontal part of the terminal element with the hole 422 provided therein) and the housing 7. A nut may alternatively be integrated in the housing 7 in a suitable way. The screw and nut in such a case may have a thread size of between M2 and M10 (DIN 13-1), for example. As can be seen, forming an electrical connection between the external connector element and the terminal element 4, and mechanically connecting the external connector element to the terminal element 4 and/or other elements of the power semiconductor module arrangement 100 can be cumbersome and cost-intensive.

In the following, different embodiments of a terminal element and methods for forming a terminal element will be described. The terminal element can be formed easily and cost-effectively by means of the described methods requiring only a few different manufacturing steps (stamping and bending). That is, the turning-milling components of conventional arrangements are replaced by sheet bent parts that are much more easy to manufacture, as will be described in the following. Such terminal elements may be easily integrated into a power semiconductor module arrangement. A connection between the terminal element and an external connector element can be easily formed in order to electrically contact the semiconductor arrangement arranged inside the housing of the power semiconductor module arrangement. No additional components are required to electrically and mechanically contact the terminal element with an external connector element.

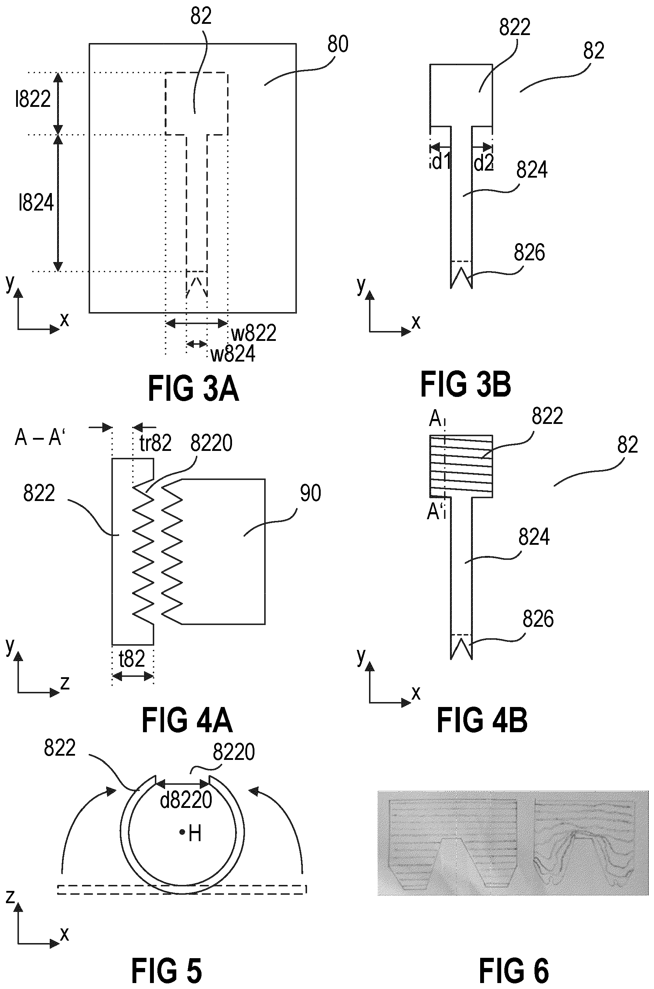

Now referring to Figures 3A and 3B, a method for forming a terminal element comprises stamping a blank 82 from a metal sheet 80, the blank 82 comprising a first section 822, and a second section 824. The second section 824 is an elongated section having a length l824 in a vertical direction y that is at least twice its width w824 in a first horizontal direction x. According to embodiments of the disclosure, the second section 824 has a length l824 that is between two and ten times, or between two and 20 times its width w824. According to one example, the width w824 of the second section 824 is between 1mm and 12mm. The first section 822 is a rectangular section having a width w822 in the first horizontal direction x that is greater than the width w824 of the second section 824. According to embodiments of the invention, the width 822 of the first section 822 is between two and ten times the width w824 of the second section 824. A length l822 of the first section 822 in the vertical direction y may be between 0.5 and 5 times its width w822 in the first horizontal direction x. The length 1822 of the first section 822 in the vertical direction y, e.g., may be between two and ten times the length l824 of the second section 824.

In the Figures, the second section 824 is arranged centrally with regard to the first section 822. That is, a first edge (left edge in the figures) of the second section 824 is arranged at a first distance d1 from the respective first edge (left edge in the figures) of the first section 822, and a second edge (right edge in the figures) of the second section 824 is arranged at a second distance d2 from the respective second edge (right edge in the figures) of the first section 824, wherein d1 = d2. This, however, is only an example. The first distance d1 may also be larger or smaller than the second distance d2. It is even possible that either the first distance d1 or the second distance d2 is zero. That is, the first edge of the second section 824 may be aligned with the first edge of the first section 822, or the second edge of the second section 824 may be aligned with the second edge of the first section 822.

Optionally, the blank 82 may further comprise a third section 826, wherein the second section 824 is arranged between the first section 822 and the third section 826. The third section 826 may comprise at least one tapered portion facing away from the second section 824. In the example illustrated in Figure 3, the (optional) third section 826 comprises two tapered portions that each taper towards the first end of the blank 82 (the end which will later be arranged inside the housing of the power semiconductor module arrangement 100). The third section 826, and especially the tapered portions, may be easily inserted (pressed) into respective holes in a substrate or printed circuit board, thereby forming a solder-free press-fit connection.

The metal sheet 80 (and therefore also the blank 82 stamped from the metal sheet 80) may have a thickness t82 in a second horizontal direction z of between 0.5mm and 3mm, or between 0.8mm and 2mm, for example (see, e.g., Figure 4A). The metal sheet 80 may comprise or consist of a material such as, e.g., aluminum or copper, for example. Optionally, the metal sheet 80 may be nickel plated, tin plated or silver plated before performing the stamping step.

The method for forming a terminal element further comprises forming a thread on a surface of the first section 822, and bending the first section 822 to form a sleeve, wherein the sleeve comprises an opening facing in the vertical direction y towards the second section 824, which will be described in further detail below. According to one example and as is described by means of Figures 4 and 5, the thread may be formed after stamping the blank 82 and before bending the first section 822. That is, the thread may be formed while the first section 822 is still flat, as is schematically illustrated in Figure 4. Referring to Figure 4A, the thread may be formed by means of an embossing tool 90, for example. That is, the thread may be formed by compressing material of the first section 822 in defined areas, instead of cutting the thread. When cutting a thread, material is removed, which is not the case when compressing the material. This is schematically illustrated in Figure 6. In particular, Figure 6 schematically illustrates the fiber orientation after cutting a thread (left side) and after shaping a thread by compressing defined areas of the material (right side). A plurality of fibers are cut through when cutting a thread. The overall orientation of the fibers, however, remains flat. This is not the case when the thread is shaped. As can be seen on the right side of Figure 6, the density of fibers is increased in those areas where the material is compressed (e.g., in the range of the flanks of the thread), resulting in a greater static and dynamic strength of the material. When shaping a thread, the original thickness t82 may be reduced to a reduced thickness tr82 in defined areas. The reduced thickness tr82 may be between 50% and 80% of the original thickness t82, for example.

As is schematically illustrated in Figure 4B, the thread may only be formed on the first section 822, but not on the second section 824 and the optional third section 826. According to one example, a thread is formed over the entire length l822 of the first section 822. This, however, is only an example. It is generally possible, that certain areas of the first section 822 remain free of the thread. According to another embodiment of the disclosure, a thread is formed over between 50% and 100% of the length l822 of the first section 822. Figure 4A schematically illustrates a cross-sectional view along a section plane A - A', as is indicated in Figure 4B. As is schematically illustrated in Figure 5, the first section 822 is then bent such that the thread is arranged on an inner surface of the resulting sleeve. Figure 5 schematically illustrates a top view on the resulting terminal element. The sleeve may have a round shape. The first section 822 is bent around a cylinder axis H to form the round sleeve.

As can be seen in Figure 5, bending the first section 822 may comprise bending two opposing sides of the first section 822 toward each other, wherein, after bending the first section 822 to form a sleeve, the sleeve comprises a vertical gap 8220 between the opposing sides of the first section 822. The opposing sides of the first section 822 may be those sides of the first section 822 defining its length l822 (extending in parallel to the vertical direction y). The gap 8220 may be a comparably small gap. That is, the opposing sides of the first section 822 may contact each other such that a distance d8220 between the opposing sides of the first section 822 is essentially zero. The gap 8220, however, may also be a comparably large gap. According to one example, a distance d8220 between the opposing sides of the first section 822 defining the gap 8220 may be between 0 and 5mm.

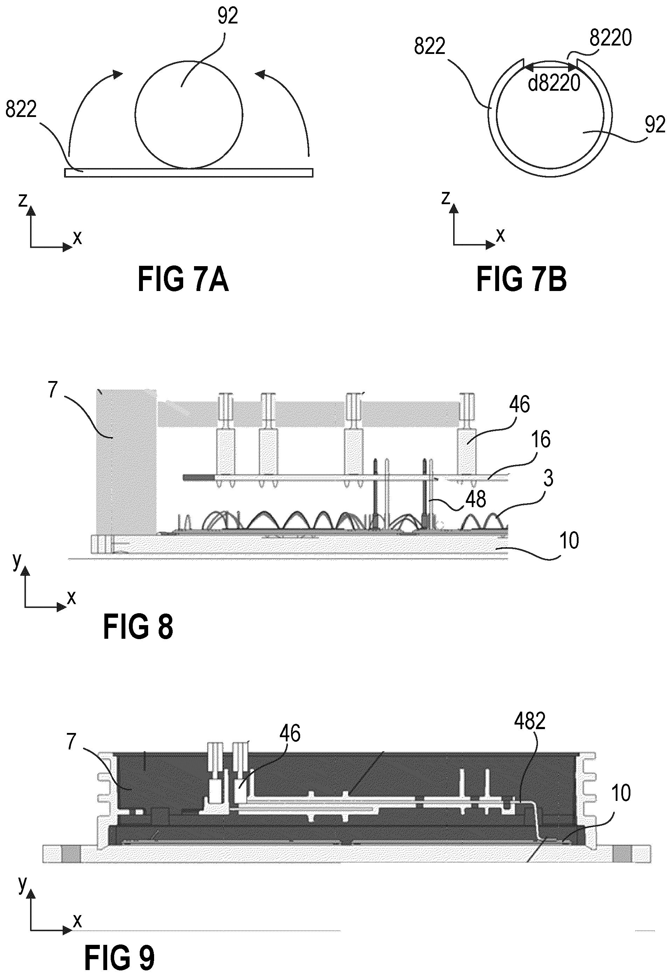

Now referring to Figure 7, it is alternatively possible to perform the steps of forming a thread on a surface of the first section 822 and bending the first section 822 to form a sleeve simultaneously. As is exemplarily illustrated in Figure 7A, the first section 822 may be wrapped around a cylindrical tool 92. The cylindrical tool 92 may comprise one or more protrusions formed on its outer circumference (not visible in the top view of Figure 7A). When the first section 822 is wrapped around the cylindrical tool 92, it may be pressed against its outer circumference. In this way, the protrusions formed on the outer circumference of the cylindrical tool 92 are pressed into the material of the first section 822. In this way, the thread may be formed by compressing defined areas of the first section 822, similar to what has been described with respect to Figure 4A above. Figure 7B schematically illustrates the first section 822 wrapped around the cylindrical tool 92. A gap 8220 may remain between the two opposing ends of the first section 822, similar to what has been described with respect to Figure 5 above. The cylindrical tool 92 may subsequently be removed by unscrewing it from the thread that has been formed on the first section 822, for example. It is, however, also possible that due to an elastic swing back effect a distance between the cylindrical tool 92 and the first section 822 is large enough such that the cylindrical tool 92 can be easily removed from the first section 822 without having to unscrew it. Such a dynamic swing back effect may be especially strong, for example, if the blank consists of or comprises bronze or a brass alloy having strong elastic features.

According to an even further example, it is even possible that the steps of stamping a blank 82 from a metal sheet 80, as illustrated in Figure 3, and forming a thread on a surface of the first section 822 are performed simultaneously. That is, a stamping process and a thread shaping process may be performed simultaneously. The thread in this case may also be formed by means of an embossing tool 90, for example, similar to what has been described with respect to Figure 4A above. It is also possible, that a combined stamping and embossing tool (not specifically illustrated) is used for a combined step of stamping the blank 82 and forming the thread, for example.

According to an even further example, it is also possible to form the thread only after bending the first section 822 to form a sleeve. In this case, the thread may be cut into the first section 822 by means of known thread cutting methods, for example. However, as has been described above, cutting a thread may have certain disadvantages as compared to shaping a thread.

A resulting terminal element comprises a metal piece, the metal piece comprising a first section 822, and a second section 824. The second section 824 is an elongated section having a length l824 in a vertical direction y that is at least twice its width w824 in a first horizontal direction x. The first section 822 forms a sleeve, wherein the sleeve comprises an opening facing in the vertical direction y towards the second section 824. That is, a cylinder axis H of the sleeve extends in the vertical direction y. The first section 822 comprises a thread on its inner surface. The terminal element is formed from a single metal piece, as has been described by means of Figures 3 to 7 above. As has been described above, the metal sheet 80 from which the blank 82 is formed may have a thickness t82 of between 0.5mm and 3mm, or between 0.8mm and 2mm, for example. That is, the resulting terminal element may also have a thickness t82 of between 0.5mm and 3mm, or between 0.8mm and 2mm. The thickness t82 of the first section 822 may be reduced to a reduced thickness tr82 in defined areas to form the thread. The thickness t82 of the first section 822 essentially defines a difference between an outer diameter and an inner diameter of the sleeve formed by the first section 822.

Now referring to Figure 8, a power semiconductor module arrangement according to one embodiment of the disclosure is schematically illustrated. The power semiconductor module arrangement comprises a housing 7 and a substrate 10 arranged in or forming a bottom of the housing 7, the substrate 10 comprising a dielectric insulation layer 11 and a first metallization layer 111 attached to the dielectric insulation layer 11, similar to what has been described with respect to Figure 1 above. A semiconductor arrangement may be arranged on the substrate 10. The power semiconductor module arrangement further comprises one or more terminal elements 46, wherein a first end of each of the one or more terminal elements 46 is arranged inside the housing 7, and a second end of each of the one or more terminal elements 46 extends to the outside of the housing 7. The first end of at least one of the terminal elements 46 may be electrically and mechanically coupled to the substrate 10, similar to what has been described with respect to Figure 1 above. It is, however, also possible that the power semiconductor module arrangement further comprises a printed circuit board 16 arranged in parallel to the substrate 10 inside the housing 7, as is illustrated in Figure 8. The first end of one or more of the terminal elements 46, instead of to the substrate 10, may be electrically and mechanically coupled to the printed circuit board 16. An electrical and mechanical connection between a printed circuit board 16 and the substrate 10 may be provided by means of a plurality of terminal elements 48 of a second type. The terminal elements 48 of the second type may be simple pins (e.g., press-fit pins), for example. An electrical and mechanical connection between a printed circuit board 16 and the substrate 10 may alternatively or additionally be provided in any other suitable way.

Irrespective of whether the terminal elements 46 are connected to the substrate 10 or to a printed circuit board 16, the sleeve formed by the first section 822 of each of the one or more terminal elements 46 extends through a different one of a plurality of openings formed in a cover or lid of the housing 7. This allows to contact the terminal elements 46 from outside of the housing 7. In particular, an external connector element may be inserted into a sleeve of the one or more terminal elements 46. The external connector element may be screwed into the terminal element 46, for example. That is, the external connector element may comprise a thread formed on its outer surface.

As has been described by means of Figure 3 above, a terminal element 46 may further comprise a third section 826. As is schematically illustrated in Figure 8, a printed circuit board 16 may comprise through holes, and each of the at least one tapered section of the third section 826 may be inserted into a different one of the through holes, for example. The tapered sections may be soldered to or simply pressed into the printed circuit board 16, for example. The terminal elements 46, however, may be mechanically and electrically coupled to the printed circuit board 16 or to the substrate 10 in any other suitable way.

The housing 7 may comprise sidewalls and a cover or lid, for example, as is schematically illustrated in Figures 1 and 8. Alternatively, it is also possible that the housing 7 is a molded casing, as is schematically illustrated in Figure 9. The terminal elements 46 in this example may extend to the outside of the housing 7, similar to what has been described above. In this example, however, the terminal elements 46 may be molded into the material of the housing 7, for example. The terminal elements 46 may be directly connected to the substrate 10, or may be connected to the substrate 10 by means of auxiliary connection elements 482, as is schematically illustrated in Figure 9. Auxiliary connection elements 482 may comprise conductor rails or bus bars, for example.

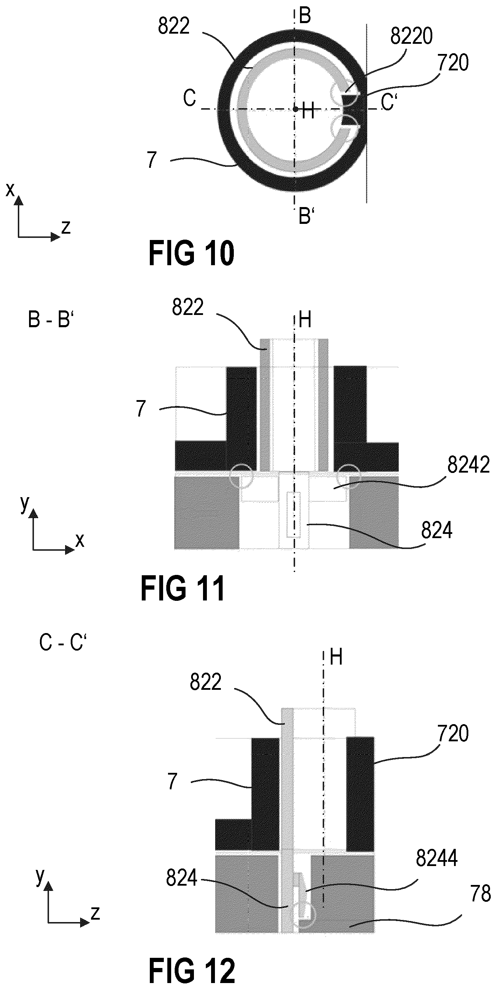

As has been described above, the sleeve of the terminal elements 46 may comprise a vertical gap 8220. According to one example, and as is schematically illustrated in Figure 10, the respective opening in the cover or lid of the housing 7 through which the terminal element extends may comprise a protrusion 720 extending into the vertical gap 8220, when the sleeve (first section 822) of the terminal element is arranged in the opening. In this way, the terminal element may be prevented from rotating out of a desired position, for example. Further, the second section 824 may comprise additional elements in order to prevent vertical movement of the terminal element. As is schematically illustrated in Figure 11, the second section 824 may comprise protrusions 8242. For example, the second section 824 may comprise two protrusions 8242, wherein each of the two protrusions 8242 is arranged on an opposite side of the second section 8242 and extends horizontally away (in the first horizontal direction x) from the second section 824. The protrusions 8242 may be arranged adjacent to the first section 822. The protrusions 8242 may locally increase the width w824 of the second section 824. The increased width of the second section 824 is larger than a diameter of the opening in the housing 7 through which the terminal element extends. The protrusions 8242 are arranged inside the housing 7 and prevent the terminal element from moving vertically away from the substrate 10.

As is schematically illustrated in Figure 12, the second section 824 may further comprise a third protrusion 8244 extending from the second section 824 in a second horizontal direction z that is perpendicular to the first horizontal direction x. The third protrusion 8244 may be or may comprise a snap-fit connection. The third protrusion 8244 may engage with a corresponding protrusion formed in the housing 7 or in a frame 78 arranged inside the housing 7 and may prevent the terminal element from moving vertically in the direction of the substrate 10. The first, second and third protrusions 8242, 8244 described with respect to Figures 11 and 12, however, are only examples. A vertical movement or a rotation of the terminal element may also be prevented in any other suitable way. For example, the mechanical and electrical connection formed between the terminal element and the substrate 10 or between the terminal element and a printed circuit board 16 may be sufficient to prevent any vertical movements of the terminal element.

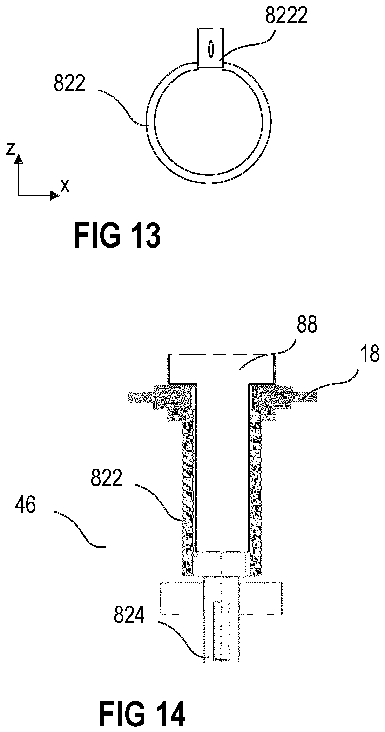

According to another example, and as is schematically illustrated in Figure 13, the vertical gap 8220 may be closed by connecting the opposing sides of the first section 822 to each other. Connecting the opposing sides of the first section 822 to each other may comprise a welding process. The resulting sleeve, therefore, may comprise a welding seam or at least one spot weld 8222, for example.

As has been described with respect to Figure 8 above, a power semiconductor module arrangement may comprise an internal printed circuit board 16. Alternatively or additionally it is also possible that the power semiconductor module arrangement comprises an external printed circuit board 18 arranged outside of the housing 7 and in parallel to the substrate 10. Such an external printed circuit board 18 may be electrically and mechanically coupled to a terminal element 46 by means of a screw 88, for example. A printed circuit board generally comprises a dielectric insulation layer with a plurality of conductor tracks arranged thereon. The printed circuit board 18 may comprise through holes, wherein a diameter of a through hole is less than a diameter of the sleeve formed by the first section 822 of the terminal element 46. The terminal element 46 may be arranged below and aligned with a respective through hole. When a screw 88 is arranged in the through hole and screwed into the sleeve, sections of the printed circuit board adjacent to the through hole are arranged between a screw head of the screw 88 and the sleeve. In particular, at least one conductor track may be arranged between a screw head of the screw 88 and the sleeve. When tightening the screw 88, the conductor track may be pressed towards the terminal element 46, thereby forming an electrical connection between the terminal element 46 and the conductor track. This is schematically illustrated in Figure 14.

## Claims

1. A method for forming a terminal element for a power semiconductor module arrangement (100) comprising:
stamping a blank (82) from a metal sheet (80), the blank (82) comprising a first section (822), and a second section (824),
wherein the second section (824) is an elongated section having a length (l824) in a vertical direction (y) that is at least twice its width (w824) in a first horizontal direction (x), and the first section (822) is a rectangular section having a width (w822) in the first horizontal direction (x) that is greater than the width (w824) of the second section (824);
forming a thread on a surface of the first section (822); and
bending the first section (822) around a cylinder axis (H) to form a round sleeve, wherein the sleeve comprises an opening facing in the vertical direction (y) towards the second section (824),
**characterized in that** the second section (824) is directly adjoining the first section (822).

2. The method of claim 1, wherein the steps of forming a thread on a surface of the first section (822) and bending the first section (822) to form a sleeve are performed simultaneously by wrapping the first section (822) around a cylindrical tool (92) comprising one or more protrusions formed on its outer circumference.

3. The method of claim 2, wherein, when the first section (822) is wrapped around the cylindrical tool (92), the first section (822) is pressed against the cylindrical tool (92) such that the one or more protrusions are pressed into the material of the first section (822), thereby forming the thread.

4. The method of claim 1, wherein the thread is formed before bending the first section (822), and the first section (822) is bent such that the thread is arranged on an inner surface of the sleeve.

5. The method of claim 1, wherein
either the steps of stamping a blank (82) from a metal sheet (80) and forming a thread on a surface of the first section (822) are performed simultaneously, or
the step of forming a thread on a surface of the first section (822) is performed after the step of stamping a blank (82) from a metal sheet (80).

6. The method of claim 4 or 5, wherein the thread is formed by means of an embossing tool (90).

7. The method of any of claims 1 to 6, wherein stamping a blank (82) from a metal sheet (80) comprises stamping a blank (82) from a metal sheet (80) having a thickness (t82) in a second horizontal direction (z) of between 0.5mm and 3mm, or between 0.8mm and 2mm.

8. The method of any of the preceding claims, wherein bending the first section (822) comprises bending two opposing sides of the first section (822) toward each other.

9. The method of claim 8, wherein, after bending the first section (822) to form a sleeve, the sleeve comprises a vertical gap (8220) between the opposing sides of the first section (822).

10. The method of claim 9, further comprising connecting the opposing sides of the first section (822) to each other, thereby closing the gap (8220).

11. The method of claim 10, wherein connecting the opposing sides of the first section (822) to each other comprises a welding process.

12. A terminal element formed by the method of claim 1, the terminal element comprising a metal piece, the metal piece comprising
a first section (822); and
a second section (824) directly adjoining the first section (822), wherein
the second section (824) is an elongated section having a length (l824) in a vertical direction (y) that is at least twice its width (w824) in a first horizontal direction (x),
the first section (822) forms a round sleeve around a cylinder axis (H), wherein the sleeve comprises an opening facing in the vertical direction (y) towards the second section (824);
the first section (822) comprises a thread on its inner surface.

13. The terminal element of claim 12, wherein the metal piece has a thickness (t82) of between 0.5mm and 3mm, or between 0.8mm and 2mm.

14. A power semiconductor module arrangement (100) comprises:
a housing (7);
a substrate (10) arranged in or forming a bottom of the housing (7), the substrate (10) comprising a dielectric insulation layer (11) and a first metallization layer (111) attached to the dielectric insulation layer (11);
a semiconductor arrangement arranged on the substrate (10); and
one or more terminal elements according to claim 12 or 13, wherein
a first end of each of the one or more terminal elements is arranged inside the housing (7), and a second end of each of the one or more terminal elements extends to the outside of the housing (7).

15. The power semiconductor module arrangement (100) of claim 14, wherein
the sleeve formed by the first section (822) of each of the one or more terminal elements extends through a different one of a plurality of openings formed in a cover or lid of the housing (7),
the sleeve comprises a vertical gap (8220), and
the respective opening in the cover or lid of the housing (7) comprises a protrusion (720) extending into the vertical gap (8220).

## Patentansprüche

1. Verfahren zur Bildung eines Anschlusselements für eine Leistungshalbleitermodulanordnung (100), umfassend:
Stanzen eines Rohlings (82) aus einem Blech (80), wobei der Rohling (82) einen ersten Abschnitt (822) und einen zweiten Abschnitt (824) umfasst,
wobei der zweite Abschnitt (824) ein länglicher Abschnitt mit einer Länge (1824) in einer vertikalen Richtung (y) ist, die mindestens doppelt so groß wie seine Breite (w824) in einer ersten horizontalen Richtung (x) ist, und der erste Abschnitt (822) ein rechteckiger Abschnitt ist, dessen Breite (w822) in der ersten horizontalen Richtung (x) größer als die Breite (w824) des zweiten Abschnitts (824) ist;
Bilden eines Gewindes auf einer Oberfläche des ersten Abschnitts (822); und
Biegen des ersten Abschnitts (822) um eine Zylinderachse (H), um eine runde Hülse zu formen, wobei die Hülse eine Öffnung aufweist, die in vertikaler Richtung (y) zum zweiten Abschnitt (824) zeigt,
**dadurch gekennzeichnet, dass** der zweite Abschnitt (824) unmittelbar an den ersten Abschnitt (822) angrenzt.

2. Verfahren nach Anspruch 1, wobei die Schritte des Bildens eines Gewindes auf einer Oberfläche des ersten Abschnitts (822) und Biegens des ersten Abschnitts (822) zum Bilden einer Hülse gleichzeitig durchgeführt werden, indem der erste Abschnitt (822) um ein zylindrisches Werkzeug (92) gewickelt wird, das einen oder mehrere Vorsprünge umfasst, die an dessen Außenumfang gebildet sind.

3. Verfahren nach Anspruch 2, wobei, wenn der erste Abschnitt (822) um das zylindrische Werkzeug (92) gewickelt wird, der erste Abschnitt (822) so gegen das zylindrische Werkzeug (92) gedrückt wird, dass der eine oder die mehreren Vorsprünge in das Material des ersten Abschnitts (822) gedrückt werden, wodurch das Gewinde gebildet wird.

4. Verfahren nach Anspruch 1, wobei das Gewinde vor dem Biegen des ersten Abschnitts (822) gebildet wird und der erste Abschnitt (822) so gebogen wird, dass das Gewinde auf einer Innenfläche der Hülse angeordnet ist.

5. Verfahren nach Anspruch 1, wobei
entweder die Schritte des Stanzen eines Rohlings (82) aus einem Blech (80) und des Bildens eines Gewindes auf einer Oberfläche des ersten Abschnitts (822) gleichzeitig durchgeführt werden, oder
der Schritt des Bildens eines Gewindes auf einer Oberfläche des ersten Abschnitts (822) nach dem Schritt des Stanzens eines Rohlings (82) aus einem Blech (80) durchgeführt wird.

6. Verfahren nach Anspruch 4 oder 5, wobei das Gewinde mittels eines Prägewerkzeugs (90) gebildet wird.

7. Verfahren nach einem der Ansprüche 1 bis 6, wobei das Stanzen eines Rohlings (82) aus einem Blech (80) das Stanzen eines Rohlings (82) aus einem Blech (80) mit einer Dicke (t82) in einer zweiten horizontalen Richtung (z) zwischen 0,5 mm und 3 mm oder zwischen 0,8 mm und 2 mm umfasst.

8. Verfahren nach einem der vorhergehenden Ansprüche, wobei das Biegen des ersten Abschnitts (822) das Biegen von zwei gegenüberliegenden Seiten des ersten Abschnitts (822) aufeinander zu umfasst.

9. Verfahren nach Anspruch 8, wobei die Hülse nach dem Biegen des ersten Abschnitts (822), um eine Hülse zu bilden, einen vertikalen Spalt (8220) zwischen den gegenüberliegenden Seiten des ersten Abschnitts (822) umfasst.

10. Verfahren nach Anspruch 9, ferner umfassend das Verbinden der gegenüberliegenden Seiten des ersten Abschnitts (822) miteinander, wodurch der Spalt (8220) geschlossen wird.

11. Verfahren nach Anspruch 10, wobei das Verbinden der gegenüberliegenden Seiten des ersten Abschnitts (822) miteinander einen Schweißvorgang umfasst.

12. Anschlusselement, das durch das Verfahren nach Anspruch 1 gebildet wird, wobei das Anschlusselement ein Metallstück umfasst, wobei das Metallstück Folgendes umfasst:
einen ersten Abschnitt (822); und
einen zweiten Abschnitt (824), der unmittelbar an den ersten Abschnitt (822) angrenzt, wobei der zweite Abschnitt (824) ein länglicher Abschnitt mit einer Länge (1824) in einer vertikalen Richtung (y) ist, die mindestens das Zweifache seiner Breite (w824) in einer ersten horizontalen Richtung (x) beträgt,
der erste Abschnitt (822) eine runde Hülse um eine Zylinderachse (H) bildet, wobei die Hülse eine Öffnung umfasst, die in der vertikalen Richtung (y) zu dem zweiten Abschnitt (824) weist;
der erste Abschnitt (822) an seiner Innenfläche ein Gewinde aufweist.

13. Anschlusselement nach Anspruch 12, wobei das Metallstück eine Dicke (t82) zwischen 0,5 mm und 3 mm oder zwischen 0,8 mm und 2 mm aufweist.

14. Leistungshalbleitermodulanordnung (100), umfassend:
ein Gehäuse (7);
ein Substrat (10), das in dem Gehäuse (7) angeordnet ist oder eine Unterseite davon bildet, wobei das Substrat (10) eine dielektrische Isolationsschicht (11) und eine erste Metallisierungsschicht (111), die an der dielektrischen Isolationsschicht (11) angebracht ist, umfasst;
eine auf dem Substrat (10) angeordnete Halbleiteranordnung; und
ein oder mehrere Anschlusselemente nach Anspruch 12 oder 13, wobei
ein erstes Ende jedes des einen oder der mehreren Anschlusselemente innerhalb des Gehäuses (7) angeordnet ist und sich ein zweites Ende jedes des einen oder der mehreren Anschlusselemente zur Außenseite des Gehäuses (7) erstreckt.

15. Leistungshalbleitermodulanordnung (100) nach Anspruch 14, wobei sich die durch den ersten Abschnitt (822) jedes des einen oder der mehreren Anschlusselemente gebildete Hülse durch eine andere von einer Mehrzahl von Öffnungen erstreckt, die in einer Abdeckung oder einem Deckel des Gehäuses (7) gebildet sind,
die Hülse einen vertikalen Spalt (8220) aufweist, und
die jeweilige Öffnung im Deckel des Gehäuses (7) einen Vorsprung (720) aufweist, der sich in den vertikalen Spalt (8220) erstreckt.

## Revendications

1. Un procédé de formation d'un élément de borne pour un agencement (100) de module à semiconducteur de puissance comprenant :
estamper un flan (82) dans une tôle (80) métallique, le flan (82) comprenant une première partie (822) et une deuxième partie (824),
dans lequel la deuxième partie (824) est une partie oblongue ayant une longueur (1824) dans une direction (y) verticale, qui représente au moins deux fois sa largeur (w824) dans une première direction (x) horizontale, et la première partie (822) est une partie rectangulaire ayant une largeur (w822) dans la première direction (x) horizontale, qui est plus grande que la largeur (w824) de la partie (824) ;
former un filet sur une surface de la première partie (822) ; et
courber la première partie (822) autour d'un axe (H) de cylindre pour former un manchon de section droite circulaire, dans lequel le manchon comprend une ouverture faisant face dans la direction (y) verticale vers la deuxième partie (824),
**caractérisé en ce que** la deuxième partie (824) est adjointe directement la première partie (822).

2. Le procédé de la revendication 1, dans lequel les stades de formation d'un filet sur une surface de la première partie (822) et la courbure de la première partie (822) pour former un manchon sont effectués simultanément en enroulant la première partie (822) autour d'un outil (92) cylindrique comprenant une ou plusieurs saillies formées sur sa circonférence extérieure.

3. Le procédé de la revendication 2, dans lequel, lorsque la première partie (822) est enroulée autour de l'outil (92) cylindrique, la première partie (822) est pressée sur l'outil (92) cylindrique de manière à presser la une ou les plusieurs saillies dans le matériau de la première partie (822) en formant ainsi le filet.

4. Le procédé de la revendication 1, dans lequel le filet est formé avant de courber la première partie (822) et la première partie (822) est courbée de manière à ce que le filet soit disposé sur une surface intérieure du manchon.

5. Le procédé de la revendication 1, dans lequel
ou bien les stades d'estampage d'un flan (82) dans une tôle (80) métallique et de formation d'un filet à la surface de la première partie (822) sont effectués simultanément, ou bien
le stade de formation d'un filet à la surface de la première partie (822) est effectué après le stade d'estampage d'un flan (82) dans une tôle (80) métallique.

6. Le procédé de la revendication 4 ou 5, dans lequel le filet est formé au moyen d'un outil (90) d'embossage.

7. Le procédé de l'une quelconque des revendications 1 à 6, dans lequel estamper un flan (82) dans une tôle (80) métallique comprend estamper un flan (82) dans une feuille (80) métallique d'une épaisseur (t82) dans une deuxième direction (z) horizontale comprise entre 0,5 mm et 3 mm ou entre 0,8 mm et 2 mm.

8. Le procédé de l'une quelconque des revendications précédentes, dans lequel courber la première partie (822) comprend courber deux côtés opposés de la première partie (822) l'un vers l'autre.

9. Le procédé de la revendication 8, dans lequel, après avoir courbé la première partie (822) pour former un manchon, le manchon comprend un intervalle (8220) vertical entre les côtés opposés de la première partie (822).

10. Le procédé de la revendication 9, comprenant en outre relier les côtés opposés de la première partie (822) l'un à l'autre en fermant ainsi l'intervalle (8220).

11. Le procédé de la revendication 10, dans lequel relier les côtés opposés de la première partie (822) l'un à l'autre comprend une opération de soudage.

12. Un élément de borne formé par le procédé de la revendication 1, l'élément de borne comprenant une pièce métallique, la pièce métallique comprenant
une première partie (822) ; et
une deuxième partie (824) adjointe directement à la première partie (822), dans lequel
la deuxième partie (824) est une partie oblongue ayant une longueur (1824) dans une direction (y) verticale, qui représente au moins deux fois sa largeur (w824) dans une première direction (x) horizontale,
la première partie (822) forme un manchon de section droite circulaire autour d'un axe (H) de cylindre, dans lequel le manchon comprend une ouverture faisant face dans la direction (y) verticale vers la deuxième partie (824) ;
la première partie (822) comprend un filet sur sa surface intérieure.

13. L'élément de borne de la revendication 12, dans lequel la pièce métallique a une épaisseur (t82) comprise entre 0,5 mm et 3 mm ou entre 0,8 mm et 2 mm.

14. Un agencement (100) de module à semiconducteur de puissance comprenant :
un boîtier (7) ;
un substrat (10) agencé dans ou formant un fond du boîtier (7), le substrat (10) comprenant une couche (11) diélectrique isolante et une première couche (111) de métallisation fixée à la couche (11) diélectrique isolante ;
un agencement à semiconducteur disposé sur le substrat (10) ; et
un ou plusieurs éléments de borne suivant la revendication 12 ou 13, dans lequel
une première extrémité de chacun du un ou des plusieurs éléments de borne est disposé à l'intérieur du boîtier (7), et une deuxième extrémité de chacun du un ou des plusieurs éléments de borne s'étend à l'extérieur du boîtier (7).

15. L'agencement (100) de module à semiconducteur de puissance suivant la revendication 14, dans lequel
le manchon formé par la première partie (822) de chacun du un ou des plusieurs éléments de borne s'étend dans l'une différente d'une pluralité d'ouvertures formées dans un recouvrement ou un couvercle du boîtier (7),
le manchon comprend un intervalle (8220) vertical, et
l'ouverture respective dans le recouvrement ou le couvercle du boîtier (7) comprend une saillie (720) s'étendant dans l'intervalle (8220) vertical.
